# EUROPEAN PATENT APPLICATION

(11) **EP 1 617 484 A1**
(43) Date of publication of application: **18.01.2006**
(21) Application number: 04820141.2
(22) Date of filing: 30.11.2004
(51) Int. Cl.: H01L 29/786

(54) **FIELD EFFECT TRANSISTOR, ELECTRICAL DEVICE ARRAY AND METHOD FOR MANUFACTURING THOSE**

(30) Priority: 08.12.2003 JP 2003409342
(71) Applicant: MATSUSHITA ELECTRIC INDUSTRIAL CO., LTD., Kadoma-shi, Osaka 571-8501 (JP)
(72) Inventor: NANAI, Norishige, Osaka 573-0036 (JP); TAKEUCHI, Takayuki, Osaka 567-0021 (JP)
(74) Representative: Tothill, John Paul
(86) International application number: PCT/JP2004/017748
(87) International publication number: WO 2005/057665

(57) **Abstract**

A field effect transistor of the present invention includes: a gate electrode (102) formed on a substrate (101); a gate insulation layer (103) formed on the gate electrode (101); a source electrode (106; 104) and a drain electrode (104; 106) that are formed on the gate insulation layer (103); a n-type semiconductor layer (108) including carbon nanotube, formed between the source electrode and the drain electrode so as to contact with the source electrode and the drain electrode; and a n-type modifying polymer layer formed on the n-type semiconductor layer (108), the n-type modifying polymer layer being for converting a polarity of the carbon nanotube from an original polarity of p-type into n-type and for stabilizing the polarity. The semiconductor characteristics of CNT are converted concurrently with the formation of the semiconductor protective layer, whereby the manufacturing process can be simplified. Thereby, a CNT-FET circuit that is stable even in the air can be provided.

## Description

### Technical Field

The present invention relates to field effect transistors (FETs) or thin film transistors (TFTs), and particularly relates to FETs and electrical element arrays using a semiconductor layer including carbon nanotube.

### Background Art

Currently, in field effect transistors (FETs) or thin film transistors (TFTs) used in the field of flat panel displays, the switching between a source electrode and a drain electrode, isolated from each other by a semiconductor functioning as a channel intervening therebetween, is controlled by a voltage applied to a gate electrode. TFT devices that have become commercially practical employ amorphous silicon (a-Si) or low-temperature polysilicon as the semiconductor and silicon oxide or silicon nitride as a gate insulation layer. In order to manufacture a device such as a display based on these technologies, a manufacturing process at high temperature has been required often.

Meanwhile, along with the development of technologies for flat panel displays, there have been further demands for a lighter substrate with mechanical flexibility, impact resistance and resource saving. However, a plastic board and a resin film effective for these demands have constraints when they undergo the manufacturing process at temperatures exceeding 200°C.

In recent years, organic semiconductor field effect transistors (organic FETs) also have been researched, which use organic materials showing semiconductor properties. The use of the organic materials permits thin film devices to be manufactured by a process at further lower temperature than those of a conventional a-Si and low-temperature polysilicon. Therefore, it can be expected that thin film devices can be manufactured without preparing facilities at high cost that are required for a process using silicon-based materials. Further, the manufacturing without high temperature steps facilitates the usage of a plastic board and a resin film having mechanical flexibility as a substrate, which may lead to the realization of displays and mobile equipment that are like a sheet or paper.

In the case of organic FETs using low-molecular organic semiconductor such as pentacene, the carrier mobility of a channel is smaller than that of a low-temperature polysilicon-based semiconductor layer, whose value is about 0.1 to 3 cm²/Vs (for example, non-patent document 1). However, when the crystalline interface increases or crystallinity deteriorates, the carrier mobility is decreased, resulting in a failure in practical use as TFTs.

To cope with this, FETs (CNT-FETs) using carbon nanotube (CNT) as a semiconductor layer also have been reported, the carbon nanotube having a nano structure, made of carbon and having significantly excellent conductivity and toughness properties. The CNT-FETs have large carrier mobility, and about 1,000 to 1,500 cm²/Vs has been obtained (for example, non-patent document 5). Taking advantage of this large carrier mobility of CNT, patent document 1 proposes to utilize CNT for FETs.

It is known that once CNT-FETs are exposed to the air, they show p-type characteristics. They can be converted into n-type by vacuum heating or a treatment with alkali metal. However, when they are exposed to oxygen or water, they return to p-type (non-patent document 2). Non-patent document 3, however, proposes that n-type CNT-FETs stable even in the air can be manufactured by treating CNT with an imine-based polymer such as polyethylene-imine.

When CNT is used as the semiconductor of FETs, it is preferable that both of p-type and n-type can be manufactured on the same substrate in terms of the circuit design. Non-patent document 4 proposes two methods of arranging p-type and n-type CNTs on the same substrate so as to manufacture a logical NOT circuit (NOT gate). One of the methods proposed by non-patent document 4 follows: in a circuit prepared by arranging CNTs at predetermined positions of a substrate, a pattern for FETs that should be n-type is applied with a photolithographic resin for protection, followed by vacuum heating at 200°C for 10 hours so that all of the CNT-FETs are turned into n-type once. Subsequently, this is exposed to 10⁻³ Torr of oxygen for 3 min., so that the FETs unprotected by the resin are turned into p-type so as to manufacture a NOT gate. The other method proposed by non-patent document 4 follows: in a circuit prepared by arranging CNTs at predetermined positions of a substrate, a pattern for FETs that should be p-type is applied with a photolithographic resin for protection, followed by evaporation of potassium so as to turn the FETs unprotected by the resin into n-type, thus manufacturing a NOT gate.
- Patent document 1: JP 2003-17503 A
- Non-patent document 1: C.D.Dimitrakopoulos et al. J. Appl. Phys. 80, pp.2501-2508 (1996)
- Non-patent document 2: VDerycke et al. Appl. Phys. Lett. 80, pp.2773-2775 (2002)
- Non-patent document 3: Moonsub Shim et al. J. Am. Chem. Soc. 123, pp.11512-11513 (2001)
- Non-patent document 4: VDerycke et al. Nano Lett. 1, pp.453-456 (2001)
- Non-patent document 5: S.Rosenblatt et al. Nano Lett. 2, pp.869-872 (2002)

As stated above, in order to manufacture a circuit including p-type and n-type CNT-FETs on the same substrate, a process for converting the characteristics between p-type/n-type is required in addition to a complicated process of applying a pattern by photolithography for protection, as proposed by non-patent document 4. Further, in the case where CNTs are turned into n-type using metal such as potassium, there is a need to control the amount of evaporation of potassium in order to reduce a leakage current between a source electrode and a drain electrode. In addition, although not mentioned by non-patent document 4, when the conversion into n-type is carried out using potassium, following the patterning by photolithography for protection, protective coating from the air is required as is evident from non-patent document 2. In this way, according to the conventional methods for manufacturing a circuit including p-type and n-type CNT-FETs on the same substrate, the device has to undergo a time-consuming process of vacuum heating for a long time so as to manufacture n-type CNTs, or some measure for reducing a leakage current has to be devised for the case of using metal such as potassium. As additional problems, a complicated process as a whole including patterning, conversion of characteristics and sealing is required.

### Disclosure of Invention

In order to cope with these conventional problems, the present invention provides a field effect transistor and an electrical element array that are stable in the air, which can be manufactured by a process allowing a circuit including p-type and n-type CNT-FETs on the same substrate to be manufactured by a simpler process than conventionally.

A field effect transistor of the present invention includes: a gate electrode formed on a substrate; a gate insulation layer formed on the gate electrode: a source electrode and a drain electrode that are formed on the gate insulation layer; a n-type semiconductor layer including carbon nanotube, formed between the source electrode and the drain electrode so as to contact with the source electrode and the drain electrode; and a n-type modifying polymer layer formed on the n-type semiconductor layer, the n-type modifying polymer layer being for converting a polarity of the carbon nanotube from an original polarity of p-type into n-type and for stabilizing the polarity.

An electrical element array of the present invention includes: a substrate; and a n-type field effect transistor and a p-type field effect transistor that are formed on the substrate. The n-type field effect transistor includes: a gate electrode formed on the substrate; a gate insulation layer formed on the gate electrode: a source electrode and a drain electrode that are formed on the gate insulation layer; a n-type semiconductor layer including carbon nanotube, formed between the source electrode and the drain electrode so as to contact with the source electrode and the drain electrode; and a n-type modifying polymer layer formed on the n-type semiconductor layer, the n-type modifying polymer layer-being for converting a polarity of the carbon nanotube from an original polarity of p-type into n-type and for stabilizing the polarity. The p-type field effect transistor includes: a gate electrode formed on the substrate; a gate insulation layer formed on the gate electrode: a source electrode and a drain electrode that are formed on the gate insulation layer; and a p-type semiconductor layer including carbon nanotube, formed between the source electrode and the drain electrode so as to contact with the source electrode and the drain electrode.

A method for manufacturing a field effect transistor of the present invention includes the steps of: forming a gate electrode on a substrate; forming a gate insulation layer on the gate electrode; forming a source electrode and a drain electrode on the gate insulation layer; forming a semiconductor layer including carbon nanotube on the gate insulation layer and between the source electrode and the drain electrode; and forming a n-type modifying polymer layer on the semiconductor layer by dispensing with an ink-jet method, the n-type modifying polymer layer being for converting a polarity of the carbon nanotube from an original polarity of p-type into n-type and for stabilizing the polarity.

A method for manufacturing an electrical element array including a n-type field effect transistor and a p-type field effect transistor on a substrate includes the steps of: forming a gate electrode on a substrate; forming a gate insulation layer on the gate electrode; forming a source electrode and a drain electrode on the gate insulation layer; forming a semiconductor layer including carbon nanotube on the gate insulation layer and between the source electrode and the drain electrode; and forming a n-type modifying polymer layer only on a part of the semiconductor layer that should be converted into n-type by dispensing in an ink-jet method, the n-type modifying polymer layer being for converting a polarity of the carbon nanotube from an original polarity of p-type into n-type and for stabilizing the polarity.

### Brief Description of Drawings

[Fig. 1A] Fig. 1A is a cross-sectional view of a field effect transistor of Example 1 of the present invention.
[Fig. 1B] Fig. 1B is a circuit diagram of Fig. 1A.
[Fig. 2] Fig. 2 is a schematic view of a manufacturing process of a field effect transistor according to Example 1 of the present invention.
[Fig. 3] Fig. 3 is a cross-sectional view of a field effect transistor of Example 2 of the present invention.
[Fig. 4] Fig. 4 is a schematic view of a manufacturing process of a field effect transistor as shown in conventional example 1.
[Fig. 5] Fig. 5 is a schematic view of a manufacturing process of a field effect transistor as shown in conventional example 2.

### Description of the Invention

A field effect transistor of the present invention includes: a gate electrode formed on a substrate; a gate insulation layer formed on the gate electrode: a source electrode and a drain electrode that are formed on the gate insulation layer; a n-type semiconductor layer including carbon nanotube, formed between the source electrode and the drain electrode so as to contact with the source electrode and the drain electrode; and a n-type modifying polymer layer formed on the n-type semiconductor layer, the n-type modifying polymer layer being for converting a polarity of the carbon nanotube from an original polarity of p-type into n-type and for stabilizing the polarity. This configuration can prevent the conversion of the n-type semiconductor layer into p-type even in the air, so that stable transistor characteristics can be obtained even in the air.

Preferably, the n-type modifying polymer is an imine nitrogen containing polymer. As the imine nitrogen containing polymer, polyalkylene imine is preferable. Particularly, it is preferable that the polyalkylene imine is at least one selected from the group consisting of polyethylene imine, polypropylene imine and polybutylene imine.

A resin protective film further may be formed on the n-type semiconductor layer. This configuration can protect the device from influences by the moisture in the air, thus enhancing durability.

Preferably, the n-type modifying polymer is formed by an ink-jet method. By applying a polymer dissolving in solvent by an ink-jet method, the accurate application can be conducted in a fine region.

An electrical element array of the present invention includes: a substrate; and a n-type field effect transistor and a p-type field effect transistor that are formed on the substrate. The n-type field effect transistor includes: a gate electrode formed on the substrate; a gate insulation layer formed on the gate electrode: a source electrode and a drain electrode that are formed on the gate insulation layer; an-type semiconductor layer including carbon nanotube, formed between the source electrode and the drain electrode so as to contact with the source electrode and the drain electrode; and a n-type modifying polymer layer formed on the n-type semiconductor layer, the n-type modifying polymer layer being for converting a polarity of the carbon nanotube from an original polarity of p-type into n-type and for stabilizing the polarity. The p-type field effect transistor includes: a gate electrode formed on the substrate; a gate insulation layer formed on the gate electrode: a source electrode and a drain electrode that are formed on the gate insulation layer; and a p-type semiconductor layer including carbon nanotube, formed between the source electrode and the drain electrode so as to contact with the source electrode and the drain electrode. This configuration can prevent the conversion of the n-type semiconductor layer into p-type even in the air and permits the p-type semiconductor layer to remain as p-type, so that stable transistor characteristics can be obtained even in the air.

Preferably, the n-type modifying polymer is an imine nitrogen containing polymer. As the imine nitrogen containing polymer, polyalkylene imine is preferable. Particularly, it is preferable that the polyalkylene imine is at least one selected from the group consisting of polyethylene imine, polypropylene imine and polybutylene imine.

A resin protective film further may be formed on the n-type semiconductor layer. This configuration can protect the device from influences of the moisture in the air, thus enhancing durability.

Preferably, the n-type modifying polymer is formed by an ink-jet method. By applying a polymer dissolving in solvent by an ink-jet method, the accurate application can be conducted in a fine region.

Preferably, an imine nitrogen not-containing polymer is formed on the p-type semiconductor layer. As the imine nitrogen not-containing polymer, an acrylic resin such as polymethyl methacrylate (PMMA), an epoxy resin, polyolefin, polyester, polycarbonate, polystyrene, polyacrylonitrile, polyvinylidene fluoride, polyvinylidene cyanide and polyvinyl alcohol and a resin available as the gate insulation film can be used. Further, a resin capable of forming a charge-transfer complex with CNT so as to convert the CNT into p-type also is available.

A resin protective film further may be formed on the p-type semiconductor layer. This configuration can protect the device from influence of the moisture in the air, thus enhancing durability.

Preferably, the n-type modifying polymer and the imine nitrogen not-containing polymer are formed by an ink-jet method. By applying a polymer dissolving in solvent by an ink-jet method, the accurate application can be conducted in a fine region.

A method for manufacturing a field effect transistor of the present invention includes the steps of: forming a gate electrode on a substrate; forming a gate insulation layer on the gate electrode; forming a source electrode and a drain electrode on the gate insulation layer; forming a semiconductor layer including carbon nanotube on the gate insulation layer and between the source electrode and the drain electrode; and forming a n-type modifying polymer layer on the semiconductor layer by dispensing with an ink-jet method, the n-type modifying polymer layer being for converting a polarity of the carbon nanotube from an original polarity of p-type into n-type and for stabilizing the polarity. Thereby, a n-type CNT-FET can be manufactured more simply and with accuracy than with conventional technologies, and a CNT-FET circuit stable even in the air can be provided.

A method for manufacturing an electrical element array including a n-type field effect transistor and a p-type field effect transistor on a substrate includes the steps of: forming a gate electrode on a substrate; forming a gate insulation layer on the gate electrode; forming a source electrode and a drain electrode on the gate insulation layer; forming a semiconductor layer including carbon nanotube on the gate insulation layer and between the source electrode and the drain electrode; and forming a n-type modifying polymer layer only on a part of the semiconductor layer that should be converted into n-type by dispensing in an ink-jet method, the n-type modifying polymer layer being for converting a polarity of the carbon nanotube from an original polarity of p-type into n-type and for stabilizing the polarity.
Thereby, a circuit including p-type and n-type CNT-FETs on the same substrate can be manufactured more simply than conventional technologies, and a CNT-FET circuit stable even in the air can be provided. Further, since the high temperature process is not required for forming both characteristics of the semiconductor layers, a resin substrate can be used therefor.

Note here that the above-described means or configurations can be combined mutually without departing from the spirit or essential characteristics of the present invention.

The following describes examples of the present invention and comparative examples.

### (Example 1)

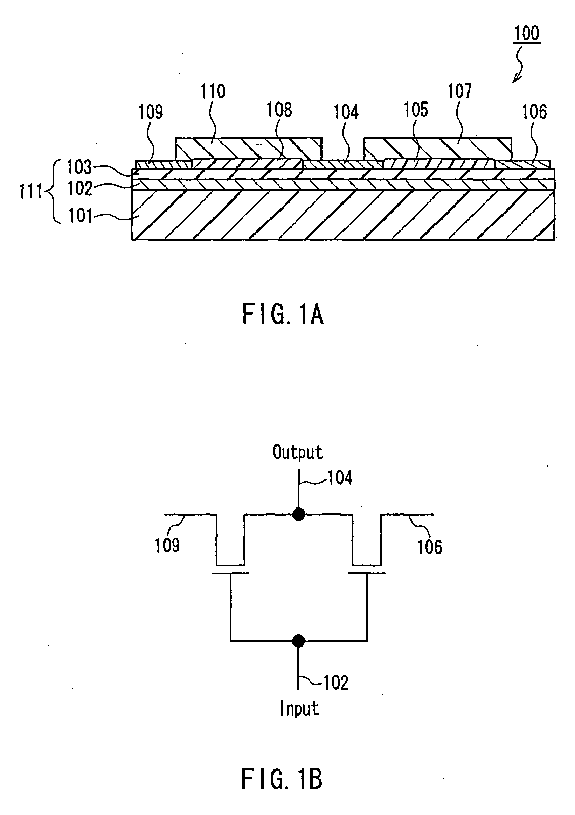

The following exemplifies as Example 1 of the present invention the case where an electrical element array is manufactured, including a NOT gate consisting of a pair of n-type FET and p-type FET. Fig. 1A schematically shows an exemplary circuit (NOT gate) in cross section configured with field effect transistors of Example 1 of the present invention. Fig. 1B is a circuit diagram of the same. In Fig. 1A, reference numeral 101 denotes a substrate, and 102 denotes a gate electrode of p-type and n-type FETs in the circuit, which functions as an input of the NOT gate. A voltage input to the gate electrode 102 enables the switching between a p-type semiconductor layer 105 and a n-type semiconductor layer 108 so as to output either of the voltages of a positive power supply electrode 106 and a negative power supply electrode 109 to an output electrode 104. As the p-type semiconductor layer and the n-type semiconductor layer, carbon nanotube (CNT) was used. The gate electrode 102 was isolated from other electrodes and semiconductor layers by a gate insulation layer 103. On the p-type semiconductor layer 105, a p-type semiconductor protective layer 107 made of polymethyl methacrylate is formed. On the n-type semiconductor layer 108, a n-type semiconductor protective layer 110 made of polyethylene-imine is formed.

Note here that a gate electrode, a source electrode and a drain electrode in the p-type FET including the p-type semiconductor layer 105 are the gate electrode 102, the source electrode 106 (or 104) and the drain electrode 104 (or 106), respectively. A gate electrode, a source electrode and a drain electrode in the n-type FET including the n-type semiconductor layer 108 are the gate electrode 102, the source electrode 109 (or 104) and the drain electrode 104 (or 109), respectively.

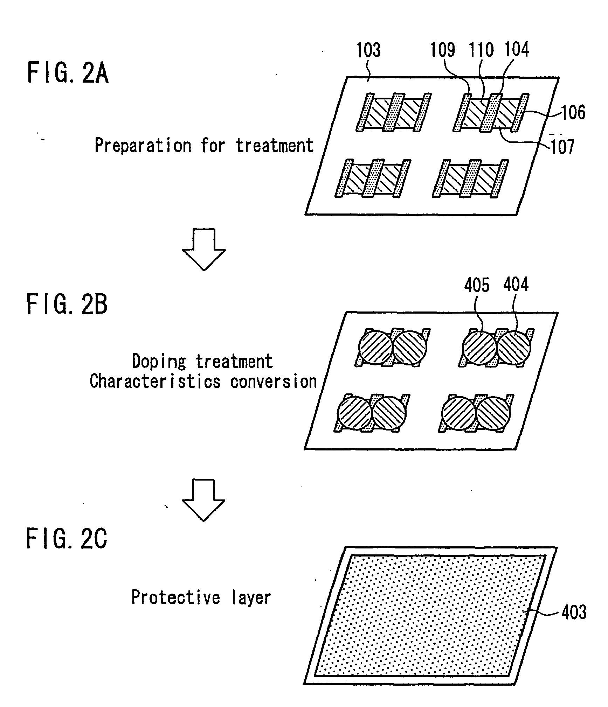

Next, a method for manufacturing the NOT gate of Figs. 1A and B is described below, with reference to Figs. 2A to C. First, a pattern of the gate electrode 102 was formed on the substrate 101 shown in Fig. 1A, and the gate insulation film 103 was formed thereon. Then, patterns of the positive power supply electrode 106, the negative power supply electrode 109 and the output electrode 104 were formed on the gate insulation film 103. Although the gate insulation film 103 preferably is thinner within a range not causing the shortage of a withstand voltage, the thickness of SiO₂ as the gate insulation film 103 in this example was set at 100 nm for reasons of the manufacturing. A distance between the positive/negative power supply electrode and the output electrode was set at 1 µm in this example for reasons of the manufacturing, but this can be set freely as long as patterning is possible. Although a width of the output electrode was set at 50 µm in this example for reasons of the wiring, FETs can operate with a thinner electrode width as well. As the substrate 101, polyimide of 0.5 mm in thickness was used. As the respective electrodes of the gate, the positive power supply and the negative power supply, gold of 0.7 to 1 µm in thickness was used, whose thickness was made thinner at portions contacting with CNTs.

Next, CNT dispersed in a solvent was applied to the entire surface of the substrate on which the patterns of the positive power supply electrode 106, the negative power supply electrode 109 and the output electrode 104 have been formed, followed by drying. In this example, dichloromethane was used as the solvent, but other solvents can be used as well as long as CNT can be dispersed therein. The concentration in this example was set at 2 mass%, but the concentration can be selected freely as long as it allows the arrangement of CNT on the electrodes. CNT was dispersed by applying ultrasonic waves for 5 min. using an ultrasonic cleaner. In this way, between the positive power supply electrode 106, the negative power supply electrode 109 and the output electrode 104, the semiconductor (CNT) layers 105 and 108 were arranged, respectively (Fig. 2A). Although in Fig. 2A CNT was formed also at portions other than between the positive power supply electrode 106 and the output electrode 104 and between the negative power supply electrode 109 and the output electrode 104, the illustration thereof was omitted. The CNT not illustrated has a large distance between the electrodes, and therefore they do not function as a semiconductor layer. The illustration of wirings between the electrodes also was omitted.

Next, an ink containing 7 mass% of polymethyl methacrylate as a protective agent of the p-type semiconductor (PMMA; average molecular weight of 46,000 to 93,000) dissolved in toluene and an ink containing 6 mass% of polyethylene-imine as a protective agent of the n-type semiconductor (average molecular weight of 10,000) dissolved in methanol were prepared, where the polyethylene-imine was a n-type modifying polymer. These inks were applied separately as a p-type semiconductor protective layer 404 and a n-type semiconductor protective layer 405, respectively, using an ink-jet method (Fig. 2B). Both of the p-type semiconductor protective layer 404 and the n-type semiconductor protective layer 405 had a substantially circular shape of about 20 to 40 µm in diameter. At this time, a part of the polyethylene-imine penetrated into the semiconductor (CNT) layer, whereby the n-type semiconductor protective layer was formed and at the same time the conversion of the characteristics of the semiconductor (CNT) layer into n-type was carried out. Therefore, no particular process for converting the characteristics was required. Both of the p-type semiconductor protective layer and the n-type semiconductor protective layer had a thickness of about 6 to 8 µm after drying. Although the ink-jet method was used as a simple technique for applying the semiconductor protective agents at the respective selected positions, any method for enabling such selective application can be used for manufacturing. According to this example, the semiconductor characteristics of the CNT are converted concurrently with the formation of the semiconductor protective layers, whereby the manufacturing process can be simplified. Finally, a protective layer 403 was provided for protecting the entire device, so that a circuit configured with the CNT-FETs could be obtained (Fig. 2C). As the protective layer 403, a photocurable polyimide resin for passivation film ("Pimel" (trade name) produced by Asahi Kasei EMD Corporation) was used, whose thickness was 30 to 100 µm.

With respect to the thus obtained NOT gate, +2.4 V was applied to the positive power supply electrode 106 and -2.4 V was applied to the negative power supply electrode 109. When +4 V was applied to the input electrode 102, the voltage of the output electrode was -1.6 V When -4 V was applied to the input electrode, the voltage of the output electrode was +1.6 V In this way, the polarities of the input and the output were reversed, thus realizing a logical NOT operation. Herein, the absolute value of the output voltage was smaller than the absolute value of the input voltage because the thickness of the gate insulation film was set larger in this example.

Since the NOT gate circuit operated normally for the positive and negative inputs, it was found that both of the p-type and the n-type CNT-FETs configuring the circuit functioned and p-type and n-type characteristics were assigned to the CNT-FETs by the semiconductor protective layers 404 and 405. This is because if two CNTFETs configuring a circuit have the same polarity, then they can operate normally for input of one polarity, but the output will be substantially 0 V for the opposite polarity.

In this Example 1, the NOT gate is exemplified as the circuit. However, since this example allows a circuit including p-type and n-type FETs on the same substrate and stable in the air to be manufactured simply, the circuit is not limited to a NOT gate. In addition to logical NOT, this example is applicable to logical OR, AND, and a logical circuit equal to the combination of them as well as a part of a display circuit that is incorporated as a switching circuit into a matrix-type panel and an information recording or information reading circuit. This example shows a manufacturing method particularly favorable for providing many FET elements on a single substrate, and therefore is particularly effective for manufacturing circuits for these.

In this Example 1, PMMA was used as the semiconductor protective layer of CNT-FETs. However, since PMMA does not contribute to the determination of polarity, this can be substituted with the protective layer 403 so that the protective layer 403 doubles as that function. Note here that the provision of the semiconductor protective layer, which does not contribute to the determination of polarity, is preferable in order to take advantage of its buffering function, which protects the semiconductor from mechanical and thermal stress occurring during the lamination of the protective layer 403 and protects the semiconductor from mechanical and thermal stress occurring during the operation or storage of the device.

In this example, since p-type CNT treated in the air was used, PMMA was used as the protective layer for the p-type CNT-FET. However, in the case where CNT converted into n-type by vacuum heating, an alkali metal/alkaline-earth metal treatment or a treatment with a nitrogen-containing functional group such as imine and imide is used, PMMA can be used as the protective layer of the n-type CNT-FET as well. This is because PMMA does not contribute to the determination of polarity.

Although PMMA was used as the p-type semiconductor protective layer in this example, any resin that does not contribute to the determination of polarity can exert similar effects. For instance, polycarbonate, polystyrene, polyacrylonitrile, polyvinylidene fluoride, polyvinylidene cyanide, polyvinyl alcohol and the like, and a resin available as the gate insulation film can be used for this purpose. Further, a resin capable of forming a charge-transfer complex with CNT so as to convert the CNT into p-type is possible as the p-type semiconductor protective layer.

Although polyethylene-imine [-(CH₂-C(CH=NH)H)ₙ-] (where n represents the polymerization degree) was used as the semiconductor protective layer that converts the characteristics of the CNT into n-type semiconductor, other imine-based resins can be used as well. Among the imine-based resins, polyethylene-imine is preferable because it is mass-manufactured and is easily available. However, polyalkylene imine such as polypropylene imine and polybutylene imine and other imine-based resins can be used as well.

Although the protective layer 403 was provided in this example, FETs can operate without the protective layer 403. Therefore, in the case where the circuit is configured in a device including other components besides the circuit, the protective layer 403 can be omitted, and the omission can be compensated with protection for the entire device. The provision of the protective layer 403 is preferable because this layer can prevent the deterioration of FETs caused by mechanical action from the outside and the inside of the device, thermal action due to for example a difference in thermal expansion coefficient between elements configuring the device, action by chemical substances intruding from the environment or included in the device configuration.

Although polyimide was used as the substrate in this example, polyester such as polyethylene terephthalate and polybutylene terephthalate and other flexible substrates can be used as well, or not-flexible substrates such as glass and silicon can be used as well. Any material can be used as the substrate of this example, as long as devices can be formed thereon.

Although gold was used as the electrodes in this example, a laminated structure including other metals such as titanium is possible in order to enhance the adherence with the substrate, or metals other than gold such as chromium, cobalt and nickel also can be used as the electrodes. Further, instead of metal, conductive polymers such as polythiophene and polypyrrole and a charge-transfer complex such as TTF-TCNQ also can be used. Further, the materials of the respective electrodes may be made different from each other and other material layers may be provided for enhancing the interface junction between the semiconductor and the electrodes, and the thicknesses of the electrodes are not limited especially, and these factors do not affect the spirit of this example.

The CNT-FET of this example was exemplified as a field effect transistor including a gate insulation layer, a semiconductor layer provided contacting with the gate insulation layer, a gate electrode contacting with the gate insulation layer and not with the semiconductor layer, a source electrode and a drain electrode provided contacting with at least one side of the semiconductor layer and sandwiching the gate electrode therebetween, which is a bottom-gate type field effect transistor whose gate electrode is provided on the substrate. However, a top-gate type field effect transistor similarly can be embodied, whose gate electrode is provided on the opposite side of the substrate relative to the semiconductor layer, and the arrangement of the electrodes does not affect the spirit of this example.

### (Example 2)

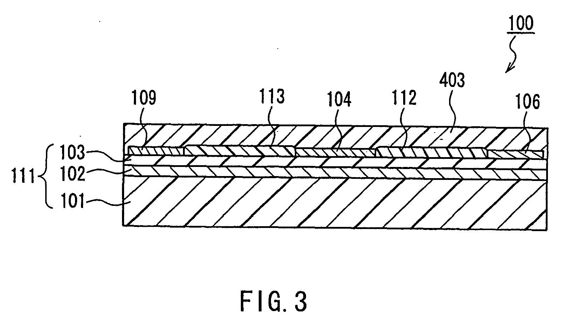

Configurations other than a p-type semiconductor layer, a n-type semiconductor layer and their protective layers were made similar to Example 1. That is, a pattern for a gate electrode 102 was formed on a substrate 101, and a gate insulation layer 103 was formed on the gate electrode 102. Then, on the gate insulation layer 103, an output electrode 104, a positive power supply electrode 106 and a negative power supply electrode 109 were produced. Thereafter, as shown in Fig. 3, an ink containing 1 mass% of polymethyl methacrylate (PMMA; average molecular weight of 46,000 to 93,000) dissolved in toluene and an ink containing 1.5 mass% of polyethylene-imine (average molecular weight of 10,000) dissolved in methanol were prepared, and these inks were applied separately as a p-type semiconductor contact layer 112 (PMMA layer) and a n-type semiconductor contact layer 113 (polyethylene-imine layer), respectively, using an ink-jet method. After the application of these polymers, before these polymers dried, CNT was deposited so that a part or all of the CNT was pushed into these polymers, whereby a p-type CNT-FET semiconductor layer (corresponding to 112) and a CNT-FET semiconductor layer whose characteristics had been converted into n-type (corresponding to 113) were formed. Both of the p-type semiconductor layer and the n-type semiconductor layer had a substantially circular shape of about 20 to 40 µm in diameter. At this time, when the CNT was brought into contact with polyethylene-imine, then the characteristics of the CNT concurrently were converted into n-type, and therefore no particular process for converting the characteristics was required. Both of the p-type semiconductor layer and the n-type semiconductor layer had a thickness of about 0.3 to 2 µm after drying.

Next, a protective layer 403 was provided for protecting the entire device, thus a circuit configured with the CNT-FETs could be obtained. As the protective layer 403, a photocurable polyimide resin for passivation film ("Pimel" (trade name) produced by Asahi Kasei EMD Corporation) was used, whose thickness was 30 to 100 µm.

The thus obtained field effect transistor 100 operated normally similar to Example 1.

### (Comparative Example 1)

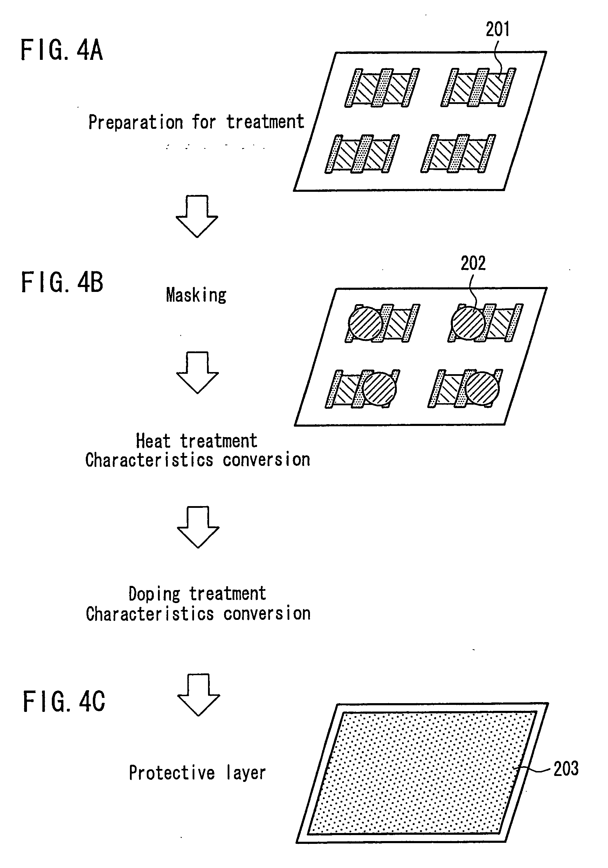

The following describes a conventional manufacturing method as a comparative example, in accordance with Figs. 4A to C. This method is based on the method proposed by non-patent document 4.

Similarly to Example 1, a gate electrode, a gate insulator and a semiconductor (CNT) layer 201 were provided on a substrate (Fig. 4A). Next, PMMA was applied as resist on the CNT 201, followed by exposure, curing and removal so as to provide a protective mask against dopant 202 (Fig. 4B). Herein, the protective mask 202 was provided at positions corresponding to CNT-FETs that would be n-type. Subsequently, this was left standing in vacuum at 200°C for 10 hours so as to turn all of the CNT from p-type into n-type. Then, when this was exposed to the air out of the vacuum, the CNT unprotected by the protective mask against dopant 202 was converted from n-type into p-type. The dopant in this case was oxygen in the air.

Next, after a circuit with the p-type and n-type CNT-FETs arranged therein was obtained, a protective layer 203 was provided (Fig. 4C).

In this way, since Comparative Example 1 required the process for converting the characteristics twice, the number of the steps increased as compared with those of Examples 1 to 2. While Examples 1 to 2 allowed the conversion of the characteristics to be performed concurrently with the step for manufacturing a protective mask, the step for converting into n-type of Comparative Example 1 took a relatively long time. From these points, it was understood that Examples 1 to 2 allowed a circuit including p-type and n-type CNT-FETs on the same substrate to be manufactured more simply than Comparative Example 1.

### (Comparative Example 2)

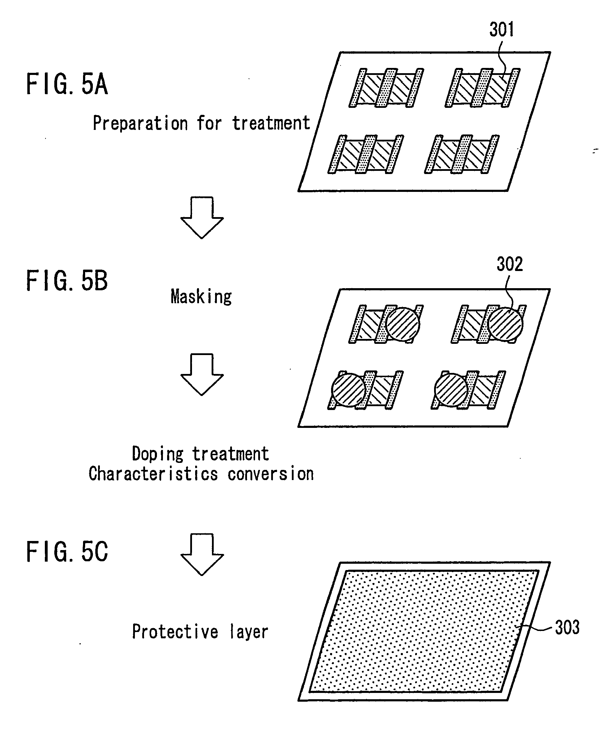

The following describes as Comparative Example 2 a conventional manufacturing method, different from Comparative Example 1, in accordance with Figs. 5A to C. This method is based on the method proposed by non-patent document 4.

Similarly to Example 1, an electrode, a gate insulator and a semiconductor (CNT) 301 were provided on a substrate (Fig. 5A). Next, PMMA was applied as resist on the CNT 301, followed by exposure, curing and removal so as to provide a protective mask against dopant 302 (Fig. 5B). Herein, unlike Comparative Example 1, the protective mask 302 was provided at positions corresponding to CNT-FETs that would be p-type. Subsequently, potassium was evaporated thereon under vacuum so as to conduct the conversion from p-type into n-type. Herein, the FETs provided with the protective mask 302 remained p-type. Note here that although this comparative example used potassium as a dopant in accordance with non-patent document 4, other alkali metals, calcium and the like can be used similarly. Herein, if the evaporation amount of metal as the dopant was excessive, a current will flow through the dopant metal, which will cause an increase in OFF current of the CNT-FETs. For that reason, the evaporation amount of the dopant should be minimized.

After a circuit with the p-type and n-type CNT-FETs arranged therein was obtained as described above, a protective layer 303 was provided (Fig. 5C). In this way, Comparative Example 2 enables the shortening of the process for converting the characteristics as compared with Comparative Example 1. However, the number of the steps in Comparative Example 2 was larger than those of Examples 1 to 2 because the step for converting the characteristics was required. This is because Examples 1 to 2 allowed the conversion of the characteristics to be performed concurrently with the step for manufacturing a protective mask. Further, in the step for conducting the conversion into n-type of Comparative Example 2, compounds such as alkali metals and calcium were used, which could not be handled in the air. On the contrary, the compounds used in Examples 1 to 2 can be handled in the air. From these points, it was understood that Examples 1 to 2 allowed a circuit including p-type and n-type CNT-FETs on the same substrate to be manufactured more simply than Comparative Example 2.

### Industrial Applicability

The present invention is applicable to various electronic equipment: such as a display like sheet or paper-form using switching elements, a driving circuit, a control circuit and the like; mobile equipment using a semiconductor circuit device; disposable equipment such as wireless IC tag; recording equipment or other electronic equipment, as well as to other industrial fields. Therefore, industrial applicability of the present invention is significantly extensive and large.

## Claims

1. A field effect transistor, comprising:
a gate electrode formed on a substrate;
a gate insulation layer formed on the gate electrode:
a source electrode and a drain electrode that are formed on the gate insulation layer;
a n-type semiconductor layer comprising carbon nanotube, formed between the source electrode and the drain electrode so as to contact with the source electrode and the drain electrode; and
a n-type modifying polymer layer formed on the n-type semiconductor layer, the n-type modifying polymer layer being for converting a polarity of the carbon nanotube from an original polarity of p-type into n-type and for stabilizing the polarity.

2. The field effect transistor according to claim 1, wherein the n-type modifying polymer is an imine nitrogen containing polymer.

3. The field effect transistor according to claim 2, wherein the imine nitrogen containing polymer is polyalkylene imine.

4. The field effect transistor according to claim 3, wherein the polyalkylene imine is at least one selected from the group consisting of polyethylene imine, polypropylene imine and polybutylene imine.

5. The field effect transistor according to claim 1, further comprising a resin protective film formed on the n-type modifying polymer layer.

6. The field effect transistor according to claim 1, wherein the n-type modifying polymer is formed by an ink-jet method.

7. An electrical element array, comprising:
a substrate; and
a n-type field effect transistor and a p-type field effect transistor that are formed on the substrate,
wherein the n-type field effect transistor, comprising:
a gate electrode formed on the substrate;
a gate insulation layer formed on the gate electrode:
a source electrode and a drain electrode that are formed on the gate insulation layer;
a n-type semiconductor layer comprising carbon nanotube, formed between the source electrode and the drain electrode so as to contact with the source electrode and the drain electrode; and
a n-type modifying polymer layer formed on the n-type semiconductor layer, the n-type modifying polymer layer being for converting a polarity of the carbon nanotube from an original polarity of p-type into n-type and for stabilizing the polarity,
wherein the p-type field effect transistor, comprising:
a gate electrode formed on the substrate;
a gate insulation layer formed on the gate electrode:
a source electrode and a drain electrode that are formed on the gate insulation layer; and
a p-type semiconductor layer comprising carbon nanotube, formed between the source electrode and the drain electrode so as to contact with the source electrode and the drain electrode.

8. The field effect transistor according to claim 7, wherein the n-type modifying polymer is an imine nitrogen containing polymer.

9. The field effect transistor according to claim 8, wherein the imine nitrogen containing polymer is polyalkylene imine.

10. The field effect transistor according to claim 9, wherein the polyalkylene imine is at least one selected from the group consisting of polyethylene imine, polypropylene imine and polybutylene imine.

11. The field effect transistor according to claim 7, further comprising a resin protective film formed on the n-type modifying polymer layer.

12. The field effect transistor according to claim 7, wherein the n-type modifying polymer is formed by an ink-jet method.

13. The electrical element array according to claim 7, further comprising a protective layer made of an imine nitrogen not-containing polymer formed on the p-type semiconductor layer.

14. The electrical element array according to claim 13, wherein the imine nitrogen not-containing polymer is at least one selected from the group consisting of an acrylic resin, an epoxy resin, polyolefin, polyester, polycarbonate, polystyrene, polyacrylonitrile, polyvinylidene fluoride, polyvinylidene cyanide and polyvinyl alcohol.

15. The electrical element array according to claim 13, wherein the n-type modifying polymer and the imine nitrogen not-containing polymer are formed by an ink-jet method.

16. A method for manufacturing a field effect transistor, comprising the steps of:
forming a gate electrode on a substrate;
forming a gate insulation layer on the gate electrode;
forming a source electrode and a drain electrode on the gate insulation layer;
forming a semiconductor layer comprising carbon nanotube on the gate insulation layer and between the source electrode and the drain electrode; and
forming a n-type modifying polymer layer on the semiconductor layer by dispensing with an ink-jet method, the n-type modifying polymer layer being for converting a polarity of the carbon nanotube from an original polarity of p-type into n-type and for stabilizing the polarity.

17. The method for manufacturing a field effect transistor according to claim 16, wherein the n-type modifying polymer is an imine nitrogen containing polymer.

18. The method for manufacturing a field effect transistor according to claim 17, wherein the imine nitrogen containing polymer is polyalkylene imine.

19. The method for manufacturing a field effect transistor according to claim 18, wherein the polyalkylene imine is at least one selected from the group consisting of polyethylene imine, polypropylene imine and polybutylene imine.

20. A method for manufacturing an electrical element array including a n-type field effect transistor and a p-type field effect transistor on a substrate, comprising the steps of:
forming a gate electrode on a substrate;
forming a gate insulation layer on the gate electrode;
forming a source electrode and a drain electrode on the gate insulation layer;
forming a semiconductor layer comprising carbon nanotube on the gate insulation layer and between the source electrode and the drain electrode; and
forming a n-type modifying polymer layer only on a part of the semiconductor layer that should be converted into n-type by dispensing in an ink-jet method, the n-type modifying polymer layer being for converting a polarity of the carbon nanotube from an original polarity of p-type into n-type and for stabilizing the polarity.
